# EUROPEAN PATENT APPLICATION

(11) **EP 4 468 361 A1**
(43) Date of publication of application: **27.11.2024**
(21) Application number: 23174583.7
(22) Date of filing: 22.05.2023
(51) Int. Cl.: H01L 29/06, H01L 29/10, H01L 29/417, H01L 29/423, H01L 29/808

(54) **TRENCH JUNCTION FIELD EFFECT TRANSISTOR INCLUDING A MESA REGION**

(71) Applicant: Infineon Technologies Austria AG, 9500 Villach (AT)
(72) Inventor: WEBER, Hans, 9500 Villach (AT); RIEGLER, Andreas, 9241 Wernberg (AT); TREU, Michael Franz, 9500 Villach (AT); AICHRIEDLER, Leo, 9722 Puch (AT)
(74) Representative: Müller Hoffmann & Partner

(57) **Abstract**

A trench junction field effect transistor, trench JFET (100), is proposed. The trench JFET (100) includes a mesa region (103) confined by first and second trenches (1061, 1062) along a first lateral direction (x1). The first and second trenches (1061, 1062) extending into a semiconductor body (102) from a first surface (108) of the semiconductor body (102). The trench JFET (100) further includes a mesa channel region (104) of a first conductivity type confined, along the first lateral direction (x1), by first and second control regions (1101, 1102) of a second conductivity type. A first pn junction (1121) is defined by the mesa channel region (104) and the first control region (1101). A second pn junction (1122) is defined by the mesa channel region (104) and the second control region (1102). The first control region (1101) is electrically coupled to a source contact (S), and the second control region (1102) is electrically coupled to a gate contact (G).

## Description

### TECHNICAL FIELD

The present disclosure is related to a semiconductor device, in particular to a trench junction field effect transistor, trench JFET, including a mesa region.

### BACKGROUND

Technology development of new generations of semiconductor devices, e.g. junction field effect transistors (JFETs), aims at improving electric device characteristics and reducing costs by shrinking device geometries. Although costs may be reduced by shrinking device geometries, a variety of tradeoffs and challenges have to be met when increasing device functionalities per unit area. For example, a trade-off between area-specific on-state resistance, RₒₙxA, and reliability requirements influenced by, for example, switching efficiency, requires design optimization.

Thus, there is a need for an improved junction field effect transistor.

### SUMMARY

An example of the present disclosure relates to a trench junction field effect transistor, trench JFET. The trench JFET includes a mesa region confined by first and second trenches along a first lateral direction. The first and second trenches extend into a semiconductor body from a first surface of the semiconductor body. The trench JFET further includes a mesa channel region of a first conductivity type confined, along the first lateral direction, by first and second control regions of a second conductivity type. A first pn junction is defined by the mesa channel region and the first control region. A second pn junction is defined by the mesa channel region and the second control region. The first control region is electrically coupled to a source contact, and the second control region is electrically coupled to a gate contact.

Another example of the present disclosure relates to a further trench junction field effect transistor. The trench JFET includes a mesa region confined by first and second trenches along a first lateral direction. The first and second trenches extend into a semiconductor body from a first surface of the semiconductor body. The trench JFET further includes a mesa channel region of a first conductivity type confined, along the first lateral direction, by first and second control regions of a second conductivity type. A first pn junction is defined by the mesa channel region and the first control region. A second pn junction is defined by the mesa channel region and the second control region. Each of the first and second trenches includes a gate or source electrode and a bottom electrode. The gate or source electrode is arranged between the bottom electrode and the first surface.

Those skilled in the art will recognize additional features and advantages upon reading the following detailed description, and upon viewing the accompanying drawings.

### BRIEF DESCRIPTION OF THE DRAWINGS

The accompanying drawings are included to provide a further understanding of the embodiments and are incorporated in and constitute a part of this specification. The drawings illustrate examples of trench JFETs and together with the description serve to explain principles of the examples. Further examples are described in the following detailed description and the claims.
Fig. 1 is a schematic and exemplary cross-sectional view for illustrating a configuration example of a trench JFET having a mesa channel region confined by control regions that are electrically coupled to different contacts.
Fig. 2 is a schematic and exemplary cross-sectional view for illustrating a configuration example of a trench JFET having a top and bottom electrode in the trenches.
Fig. 3 is a schematic and exemplary cross-sectional view for illustrating a configuration example of a trench JFET that is based on Fig. 1 and includes a conductive liner adjoining the control region at a bottom part of the trenches.
Fig. 4 is a schematic and exemplary cross-sectional view for illustrating a configuration example of a trench JFET that is based on Fig. 2 and includes conductive liners adjoining the control regions at a bottom part and at sidewalls of the trenches.
Fig. 5 is a schematic and exemplary cross-sectional view for illustrating a configuration example of a trench JFET that is based on Fig. 1 and includes a superjunction structure.
Fig. 6 is a schematic and exemplary cross-sectional view for illustrating a configuration example of a trench JFET that is based on Fig. 1 and includes a measure for electrically deactivating a mesa channel region.
Fig. 7 is a schematic and exemplary cross-sectional view for illustrating a configuration example of a trench JFET that is based on Fig. 1 and includes mesa regions having different widths.

### DETAILED DESCRIPTION

In the following detailed description, reference is made to the accompanying drawings, which form a part hereof and in which are shown by way of illustrations specific examples of trench JFETs. It is to be understood that other examples may be utilized and structural or logical changes may be made without departing from the scope of the present disclosure. For example, features illustrated or described for one example can be used in conjunction with other examples to yield yet a further example. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive connection between electrically connected elements, for example a direct contact between the concerned elements or a low-resistive connection via a metal and/or heavily doped semiconductor material. The term "electrically coupled" includes that one or more intervening element(s) adapted for signal and/or power transmission may be connected between the electrically coupled elements, for example, elements that are controllable to temporarily provide a low-resistive connection in a first state and a high-resistive electric decoupling in a second state. An ohmic contact is a non-rectifying electrical junction.

Ranges given for physical dimensions include the boundary values. For example, a range for a parameter y from a to b reads as a ≤ y ≤ b. The same holds for ranges with one boundary value like "at most" and "at least".

The terms "on" and "over" are not to be construed as meaning only "directly on" and "directly over". Rather, if one element is positioned "on" or "over" another element (e.g., a layer is "on" or "over" another layer or "on" or "over" a substrate), a further component (e.g., a further layer) may be positioned between the two elements (e.g., a further layer may be positioned between a layer and a substrate if the layer is "on" or "over" said substrate).

An example of a trench junction field effect transistor, VJFET, includes a mesa region confined by first and second trenches along a first lateral direction. The first and second trenches extend into a semiconductor body from a first surface of the semiconductor body. The trench JFET further includes a mesa channel region of a first conductivity type that may be confined, along the first lateral direction, by first and second control regions of a second conductivity type. A first pn junction is defined by the mesa channel region and the first control region. A second pn junction is defined by the mesa channel region and the second control region. The first control region is electrically coupled to a source contact, and the second control region is electrically coupled to a gate contact.

The first lateral direction may be a transverse direction of the mesa region that may be perpendicular to a second lateral direction. The second lateral direction may be a longitudinal direction of the mesa region, for example. For example, a width of the mesa region or a width of the first and second trenches may be measured along the first lateral direction, for example.

The trench JFET may be part of an integrated circuit or may define a discrete semiconductor device or a semiconductor module, for example. For example, the trench JFET may be a trenched and implanted vertical-channel JFET, TI-VJFET. In a vertical-channel JFET, a load current flow is between a first load contact over the first surface of the semiconductor body and a second load contact over a second surface opposite to the first surface along the vertical direction. In the vertical-channel JFET, a load current may flow along the vertical direction perpendicular to the first and/or second surface.

The first surface may be a front surface or a top surface of the semiconductor body, and the second surface may be a back surface or a rear surface of the semiconductor body, for example. For example, the semiconductor body may be attached to a lead frame via the second surface, for example. Over the first surface of the semiconductor body, bond pads may be arranged and bond wires may be bonded on the bond pads, for example.

The semiconductor body may include or consist of a semiconductor material from the group IV elemental semiconductors, IV-IV compound semiconductor material, III-V compound semiconductor material, or II-VI compound semiconductor material. Examples of semiconductor materials from the group IV elemental semiconductors include, inter alia, silicon (Si) and germanium (Ge). Examples of IV-IV compound semiconductor materials include, inter alia, silicon carbide (SiC) and silicon germanium (SiGe). Examples of III-V compound semiconductor material include, inter alia, gallium arsenide (GaAs), gallium nitride (GaN), gallium phosphide (GaP), indium phosphide (InP), indium gallium nitride (InGaN) and indium gallium arsenide (InGaAs). Examples of II-VI compound semiconductor materials include, inter alia, cadmium telluride (CdTe), mercury-cadmium-telluride (CdHgTe), and cadmium magnesium telluride (CdMgTe). For example, the semiconductor body may a crystalline SiC semiconductor substrate having none, one or more SiC layers formed thereon. For example, the silicon carbide crystal may have a hexagonal polytype, e.g., 4H or 6H. The silicon carbide semiconductor body may be homogeneously doped or may include differently doped SiC layer portions. The silicon carbide semiconductor body may include one or more layers from another material. For example, the layers from another material may be embedded in the crystalline silicon carbide substrate. The silicon carbide semiconductor substrate may have two essentially parallel main surfaces of the same shape and size and a lateral surface area connecting the edges of the two main surfaces.

The trench JFET may be configured to conduct currents of more than 1A or more than 10 A or even more than 100 A. For example, the trench JFET may be designed as a transistor cell array of a plurality of transistor cells having a same or similar layout. The transistor cell array may be a 1-dimensional or a 2-dimensional regular arrangement of the plurality of transistor cells. For example, the plurality of transistor cells of the transistor cell array may be electrically connected in parallel. For example, source regions of the plurality of transistor cells of the trench JFET transistor cell array may be electrically connected together. Likewise, drain regions of the plurality of transistor cells of the trench JFET transistor cell array may be electrically connected together. For example, gate regions of the plurality of transistor cells of the trench JFET transistor cell array may be electrically connected together. A transistor cell of the transistor cell array or a part thereof, e.g. the gate region, may be designed in the shape of a stripe, a polygon, a circle or an oval, for example.

A number of transistor cells of the transistor cell array may depend on the maximum load current, for example. For example, a number of transistor cells of the transistor cell array may be larger than 100, or larger than 1000, or even larger than 10000, for example. The trench JFET may be further configured to block voltages between the load electrodes, e.g. between drain and source of the trench JFET, of more than 60V, 100V, 400 V, 650V, 1.2kV, 1.7kV, 3.3kV, 4.5kV, 5.5kV, 6kV, 6.5kV, 10kV. The blocking voltage may correspond to a voltage class specified in a datasheet of the trench JFET, for example. The blocking voltage of the trench JFET may be adjusted by an impurity concentration and/or a vertical extension of a drift zone in the semiconductor body. A doping concentration of the drift zone may vary along a lateral and/or vertical direction, e.g. vary gradually or in steps increase or decrease with increasing distance to the first surface at least in portions of its vertical extension. In case of superjunction devices, the doping type may vary, e.g. alternate, along the lateral direction, for example. According to other examples the impurity concentration in the drift zone may be approximately uniform. For trench JFETs based on silicon, a mean impurity concentration in the drift zone may be between 2 × 10¹² cm⁻³ and 1 × 10¹⁷ cm⁻³, for example in a range from 5 × 10¹² cm⁻³ to 1 × 10¹⁵ cm⁻³ or to 2 × 10¹⁵ cm⁻³. In the case of a trench JFET based on SiC, a mean impurity concentration in the drift zone may be between 5 × 10¹⁴ cm⁻³ and 1 × 10¹⁷ cm⁻³, for example in a range from 1 × 10¹⁵ cm⁻³ to 5 × 10¹⁶ cm⁻³. A vertical extension of the drift zone may depend on voltage blocking requirements, e.g. a specified voltage class, of the trench JFET. When operating the trench JFET in voltage blocking mode, a space charge region may vertically extend partly or totally through the drift zone depending on the blocking voltage applied to the trench JFET.

The source contact and the drain contact may be part of a wiring area over the semiconductor body. The wiring area may include one or more than one, e.g. two, three, four or even more wiring levels. Each wiring level may be formed by a single one or a stack of conductive layers, e.g. metal layer(s). The wiring levels may be lithographically patterned, for example. Between stacked wiring levels, an interlayer dielectric structure may be arranged. Contact plug(s) or contact line(s) may be formed in openings in the interlayer dielectric structure to electrically connect parts, e.g. metal lines or contact areas, of different wiring levels to one another. The source contact may be formed by one or more elements of the wiring area over the first surface. Likewise, the drain contact may be formed by one or more elements of the wiring area over the second surface.

For example, a doping concentration in the mesa channel region may be set by in-situ doping with dopants of the first conductivity type when forming a semiconductor layer on a substrate, e.g. by a layer deposition technique. The doping concentration in the mesa channel region may, in addition or as an alternative, be set by ion implantation of dopants of the first conductivity type through a sidewall of the first trench and/or a sidewall of the second trench, e.g. by one or more tilted ion implantation processes.

For example, the first and second control regions of the second conductivity type may be formed by ion implantation of dopants of the second conductivity type through a sidewall and, optionally, through a bottom side of each of the first and second trenches.

For example, after forming the mesa channel region and the first and second control regions, a trench structure may be formed in each of the first and second trenches. The trench structure may include a contact material that may be formed of one or more conductive materials, e.g. metal, metal silicide, metal compound, highly doped semiconductor material such as highly doped polycrystalline silicon. For example, the contact material may be a single layer, e.g. a highly doped polycrystalline layer, or a stack of layers. For example, the trench structure may further include a dielectric structure. The dielectric structure may include a plurality of merged dielectric parts that may differ in material, for example. The dielectric structure may be or may include an insulating material such as an oxide, e.g., SiO₂, a nitride, e.g., Si₃N₄, a high-k dielectric, or a low-k dielectric, or any combination thereof. For example, the dielectric structure may be formed as a disposed oxide (TEOS). The contact material of the trench structure in the first trench may be electrically connected to the first control region of the second conductivity type via the bottom side and/or the sidewall of the trench structure. For example, the contact material may be electrically connected to the first control region through an opening in the dielectric structure of the trench structure, e.g. at a bottom side of the trench structure. Likewise, the contact material of the trench structure in the second trench may be electrically connected to the second control region of the second conductivity type via the bottom side and/or the sidewall of the trench structure. For example, the contact material may be electrically connected to the second control region through an opening in the dielectric structure of the trench structure, e.g. at a bottom side of the trench structure. Although the trench structures in the first and second trenches may be processed together, the contact material of the trench structure in the first trench may be electrically coupled to the source contact or electrode, and the contact material of the trench structure in the second trench may be electrically coupled to the gate contact.

For example, dopants in a semiconductor body comprising SiC may include Al, B, Be, Ga, or any combination thereof for p-type doping, and N, P, or any combination thereof for n-type doping. For example, dopants in a semiconductor body comprising Si may include Al, B, Ga, In, or any combination thereof for p-type doping, and P, As, Sb, hydrogen-related donors, or any combination thereof for n-type doping.

For example, the trench JFET may further include an edge termination area that laterally separates an active trench JFET area and a field-free area and may completely surround the active trench JFET area laterally. In a blocking mode or in a reverse biased mode of the trench JFET, the blocking voltage between the active trench JFET area and the field-free area laterally drops across a termination structure in the edge termination area. The edge termination area may have a higher or a slightly lower voltage blocking capability than the active trench JFET area. The termination structure in the edge termination area may include or may a junction termination extension (JTE) with or without a variation of lateral doping (VLD), one or more laterally separated guard rings, or any combination thereof.

By electrically coupling the first control region to the source contact instead of, for example, the gate contact, the gate-to-drain capacitance Cgd and the ratio of Cgd to the gate-to-source capacitance Cgs may be reduced. This may allow for improving the switching efficiency and switching speed by reducing the amount of gate charges that have to be removed when switching. This may allow for improving the ease-of-use of trench JFETs, as well.

For example, the first trench may include a dielectric trench filling structure.

Functional or structural configuration details described with respect to the exemplary trench JFET above likewise apply to another example of a trench junction field effect transistor that includes a mesa region confined by first and second trenches along a first lateral direction. The first and second trenches extend into a semiconductor body from a first surface of the semiconductor body. The trench JFET further includes a mesa channel region of a first conductivity type confined, along the first lateral direction, by first and second control regions of a second conductivity type. A first pn junction is defined by the mesa channel region and the first control region. A second pn junction is defined by the mesa channel region and the second control region. Each of the first and second trenches includes a gate or source electrode and a bottom electrode. The gate or source electrode is arranged between the bottom electrode and the first surface.

For example, the trench JET further includes a dielectric separation region, e.g. an oxide, arranged between the bottom electrode and the gate or source electrode.

For example, each of the first and second control regions may be divided into a top part and a bottom part. The top part and the bottom part may be vertically spaced from one another by an intermediate separation region of the first conductivity type. This may allow for avoiding a short circuit between the bottom electrode and the gate or source electrode arranged above the bottom electrode, for example.

For example, the intermediate separation region may adjoin to the dielectric separation region along the first lateral direction.

For example, the trench JFET may further include a first conductive liner at a sidewall portion of at least one of the first and second trenches. The first conductive liner may be laterally arranged between a trench filling material in the at least one of the first and second trenches, e.g. a conductive material of the gate or source electrode, and a corresponding one of the first and second control regions. The first conductive liner may improve or enable an ohmic contact between the trench filling material in the at least one of the first and second trenches and a corresponding one of the first and second control regions. Moreover, the first conductive liner may improve a transverse conductivity along a longitudinal direction of the at least one of the first and second trenches. This may contribute to reducing resistive losses from the gate electrode in the trenches to a gate pad, for example. For example, the first conductive liner may be formed by a metal such as Ni or Ti that may further include additives, e.g. Al.

For example, the trench JFET may further include a second conductive liner at a bottom portion of at least one of the first and second trenches. The second conductive liner may be vertically arranged between a trench filling material in the at least one of the first and second trenches and a corresponding one of the first and second control regions. The second conductive liner may improve an ohmic contact between the trench filling material in the at least one of the first and second trenches, e.g. a conductive material of the bottom electrode, and a corresponding one of the first and second control regions. Moreover, the first conductive liner may improve a transverse conductivity along a longitudinal direction of the at least one of the first and second trenches. This may contribute to reducing resistive losses from the bottom electrode in the trenches to a corresponding contact area, e.g. a source or gate contact, for example. For example, the second conductive liner may be formed by a metal such as Ni or Ti that may further include additives, e.g. Al.

For example, the trench JFET may further include a superjunction structure arranged between a bottom side of the first and second trenches and a second surface of the semiconductor body opposite to the first surface.

For example, the superjunction structure may include a first SJ region of the first conductivity type, and a second SJ region of the second conductivity type. The first SJ region may be electrically coupled to a drain contact at the second surface of the semiconductor body and to the source contact at the first surface of the semiconductor body. The second SJ region may be electrically coupled to the first and second control regions. For example, a top side of the second SJ region may adjoin to a bottom side of the first and second control regions. For example, doping concentration profiles of the second SJ region and the first and second control regions may overlap with one another.

For example, a vertical extension of the superjunction structure may range from 50% to 2000% of a vertical extension of the first and second trenches.

For example, the trench JFET may further include a source region of the second conductivity type arranged on the one of opposite sidewalls of the mesa region that adjoins to the second trench. This may allow for improving an ohmic contact between the mesa channel region and the source contact, for example.

For example, the trench JFET may further include a second mesa region. The second mesa region may be wider than the mesa region. The second trench is laterally confined by the mesa region and the second mesa region. Mesa regions having different widths may allow for counteracting offsets in pinch-off voltages arising from different pinch-off behavior that may be caused by control regions having different potentials, for example.

For example, an extent of the mesa region along the first lateral direction may range from 200 nm to 2 µm.

For example, along the first lateral direction, the mesa channel region may include, first, second and third mesa channel sub-regions having a same extent along the first lateral direction. A concentration of dopants of the first conductivity type averaged along the first lateral direction in the second mesa channel sub-region may be larger than a concentration of dopants of the first conductivity type averaged along the first lateral direction in each of the first and third mesa channel sub-regions. By providing a trench JFET having the above relation with respect to concentration of dopants in the mesa channel region, compensation of a channel charge amount caused by an overlap of doping profiles of the first and second control regions and the mesa channel region may be reduced. This may allow for stabilizing the charge amount in the mesa channel. Thus, variability of a pinch off voltage or threshold voltage of the trench JFET may be reduced. This may further improve the ease-of-use of trench JFETs.

The examples and features described above and below may be combined.

Functional and structural details described with respect to the examples above shall likewise apply to the exemplary examples illustrated in the figures and described further below.

In the following, further examples of trench JFETs are explained in connection with the accompanying drawings. Functional and structural details described with respect to the examples above shall likewise apply to the exemplary embodiments illustrated in the figures and described further below. In the illustrated examples, the first conductivity is n-type and the second conductivity type is p-type for an n-channel trench JFET. However, the first conductivity type may also be p-type and the second conductivity type may be n-type for a p-channel trench JFET.

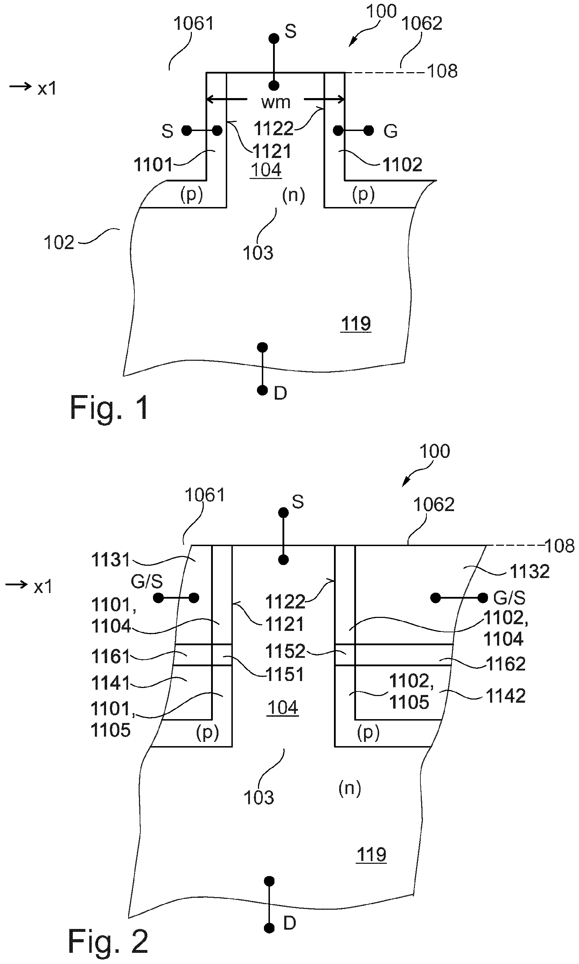

Fig. 1 schematically and exemplarily shows a cross-sectional view of a configuration example of a trench JFET 100.

The trench JFET 100 includes a mesa region 103 confined by first and second trenches 1061, 1062 along a first lateral direction x1. The first and second trenches 1061, 1062 extend into a semiconductor body 102 from a first surface 108 of the semiconductor body 102. An n-doped mesa channel region 104 is confined, along the first lateral direction x1, by first and second p-doped control regions 1101, 1102. A first pn junction 1121 is defined by the mesa channel region 104 and the first control region 1101. A second pn junction 1122 is defined by the mesa channel region 104 and the second control region 1102.

The mesa channel region 104 is electrically coupled, e.g. via a drift zone 119, to a drain contact D at a second surface of the semiconductor body. The drift zone 119 may include an n-doped drift region or may include a superjunction structure including an n-doped drift region and a p-doped compensation region, for example. The mesa channel region 104 is also electrically coupled to a source contact S at the first surface 108 of the semiconductor body 102, e.g. via an n⁺-doped source region at the first surface 108.

For example, an extent wm of the mesa region 103 along the first lateral direction x1 may range from 200 nm to 2 µm, or from 300 nm to 1.6 µm, or from 400 nm to 1.2 µm.

The first control region 1101 is electrically coupled to the source contact S, e.g. via a conductive material as part of a filling material in the first trench 1061. As an alternative, the first control region 1101 may also be electrically coupled to the source contact S via a contact on the first control region 1101 at the first surface 108. In this case, the first trench 1101 may include a dielectric trench filling structure, for example.

The second control region 1102 is electrically coupled to a gate contact G via a conductive filling material (e.g. a gate electrode) in the second trench 1062.

Fig. 2 schematically and exemplarily shows a cross-sectional view of another configuration example of a trench JFET 100.

Each of the first and second trenches 1061, 1062 includes a gate or source electrode 1131, 1132 and a bottom electrode 1141, 1142. The gate or source electrode 1131, 1132 is arranged between the bottom electrode 1141, 1142 and the first surface 108 and is electrically coupled to a gate or source contact G/S.

A capacitive behavior, e.g. C_{GD}, may be adjusted via a potential applied to the bottom electrode 1141, 1142. For example, the bottom electrode 1141 in the first trench 1061 may be electrically coupled the gate contact G and the bottom electrode 1142 in the second trench 1062 may be electrically coupled to the source contact S, or vice versa. Both bottom electrodes 1141, 1142 may also be electrically coupled to the gate contact G, or to the source contact S. While the capacitive behavior may be adjusted via the potential of each of the bottom electrodes in the trenches 1061, 1062, the current behavior may be adjusted via the potential, e.g. gate or source potential, applied to each of the gate or source electrodes 1131, 1132 in the trenches. By applying a source potential to one of the gate or source electrodes 1131, 1132, the respective trench may be deactivated with respect to control of channel conductivity, for example.

A dielectric separation region 1161, 1162 is arranged between the bottom electrode 1141, 1142 and the gate or source electrode 1131, 1132 for electrically separating the gate or source electrode 1131, 1132 and the bottom electrode 1141, 1142 in each of the trenches 1061, 1062.

Each of the first and second p-doped control regions 1101, 1102 has a top part 1104 and a bottom part 1105. The top part 1104 and the bottom part 1105 are vertically spaced from one another by an intermediate n-doped separation region 1151, 1152. Between the intermediate n-doped separation region 1151, 1152 and the p-doped first and second p-doped control regions 1101, 1102, a pn junction isolation is formed for avoiding a short-circuit between the source or gate electrode 1131, 1132 and the bottom electrode 1141, 1142. The intermediate separation region 1151, 1152 adjoins to the dielectric separation region 1161, 1162 along the first lateral direction x1.

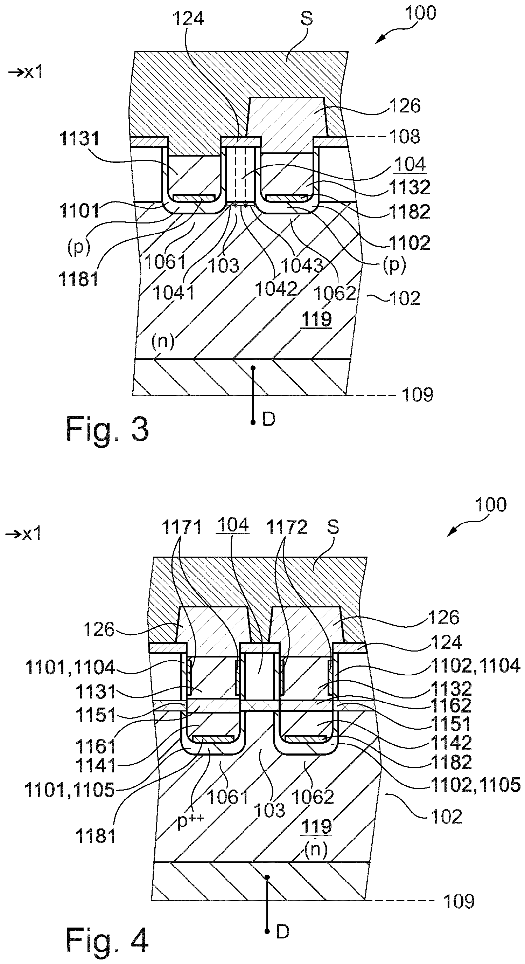

Fig. 3 schematically and exemplarily shows a cross-sectional view of another configuration example of a trench JFET 100 that is related to the example illustrated in Fig. 1.

The trench JFET 100 of Fig. 3 includes a conductive liner 1181, 1182 at a bottom portion of the first and second trenches 1061, 1062. The conductive liner 1181, 1182 is vertically arranged between the gate or source electrode 1131, 1132 in the first and second trenches 1061, 1062 and a corresponding one of the first and second control regions 1101, 1102. The first control region 1101 is electrically connected to the source contact S via the gate or source electrode 1131 in the first trench 1061. The second control region 1102 is electrically connected to a gate contact (not illustrated in Fig. 3) via the gate or source electrode 1132 in the second trench 1062. An interlayer dielectric 126 is arranged on the gate or source electrode 1132. The mesa channel region 104 is electrically coupled to the source contact S at the first surface 108 of the semiconductor body 102 via an n⁺-doped source region 124 at the first surface 108.

Along the first lateral direction x1, the mesa channel region 104 includes, first, second and third mesa channel sub-regions 1041, 1042, 1043 having a same extent along the first lateral direction x1. A concentration of n-type dopants averaged along the first lateral direction x1 in the second mesa channel sub-region 1042 is larger than a concentration of n-type dopants averaged along the first lateral direction x1 in each of the first and third mesa channel sub-regions 1041, 1043.

Fig. 4 schematically and exemplarily shows a cross-sectional view of another configuration example of a trench JFET 100 that is related to the example illustrated in Fig. 2.

Similar to the configuration example of Fig. 3, the trench JFET 100 of Fig. 4 includes a conductive liner 1181, 1182 at a bottom portion of the first and second trenches 1061, 1062. The conductive liner 1181, 1182 is vertically arranged between the bottom electrode 1141, 1142 and a corresponding one of the first and second control regions 1101, 1102.

The trench JFET 100 further includes the mesa channel region 104 having the first, second and third mesa channel sub-regions 1041, 1042, 1043 as described with reference to the configuration example of Fig. 3.

The trench JFET further includes a conductive liner 1171, 1172 at a sidewall portion of the first and second trenches 1061, 1062. The conductive liner 1171, 1172 is laterally arranged between a trench filling material, e.g. the gate or source electrode 1131, 1132, in the first and second trenches 1061, 1062 and a corresponding one of the first and second control regions 1101, 1102.

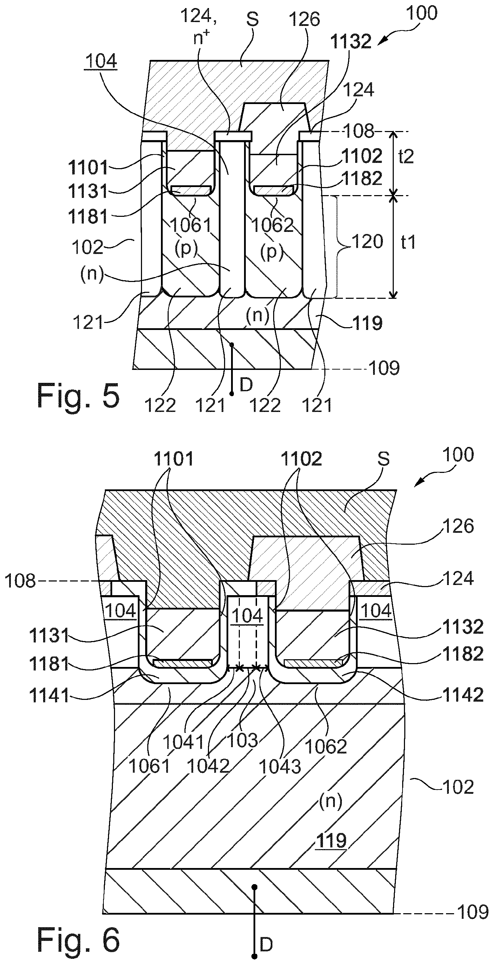

Fig. 5 schematically and exemplarily shows a cross-sectional view of another configuration example of a trench JFET 100 that is related to the example illustrated in Fig. 1.

The trench JFET 100 includes a superjunction, SJ, structure 120 arranged in the drift zone 119 between a bottom side of the first and second trenches 1061, 1062 and a second surface 109 of the semiconductor body 102 opposite to the first surface 108. The superjunction structure 120 includes a first n-doped SJ region 121 and a second p-doped SJ region 122. The first n-doped SJ region 121 is electrically coupled to a drain contact D at the second surface 109 of the semiconductor body 102. The first n-doped SJ region 121 is further electrically coupled to the source contact S at the first surface 108 of the semiconductor body 102 via the n-doped mesa channel region 104 and the n+-doped source region 124. The second SJ region 122 is electrically coupled to the p-doped first and second control regions 1101, 1102. For example, a vertical extension t1 of the superjunction structure 120 may range from 50% to 2000% of a vertical extension t2 of the first and second trenches 1061, 1062.

Fig. 6 schematically and exemplarily shows a cross-sectional view of another configuration example of a trench JFET 100 that is related to the example illustrated in Fig. 1.

The n⁺-doped source region 124 is merely arranged on the one of opposite sidewalls of the mesa region 103 that adjoins to the second trench 1062. Thus, the n⁺-doped source region 124 is omitted on the sidewall and on the top side portion of the mesa region 103 that adjoins to the first trench 1061 that adjoins to the source contact S. Thereby, the control of a channel conductivity is deactivated in the mesa region 103 at the sidewall of the second trench 1062 since the source region 124 adjoins to the intermediate dielectric 126 but not to the source contact S.

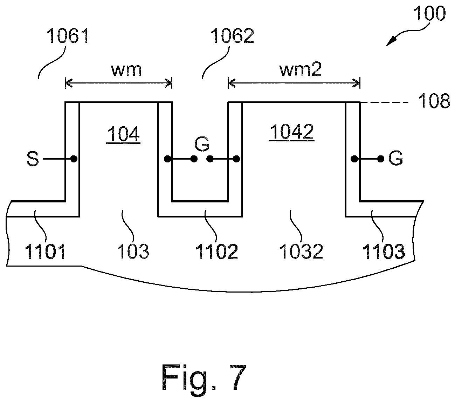

Fig. 7 schematically and exemplarily shows a cross-sectional view of another configuration example of a trench JFET 100 that is related to the example illustrated in Fig. 1.

The trench JFET 100 includes a second mesa region 1032 having a width wm2. The second mesa region 1032 is wider than the mesa region 103, i.e. wm2 > wm. The second mesa region 1032 adjoins to the second control region 1102 and to a third control region 1103. The second and the third control region 1102, 1103 are electrically coupled to the gate contact G. Thus, a second mesa channel region 1042 in the second mesa region 1032 is pinched-off via space charge regions from opposite sidewalls of the second mesa region 1032. In the mesa region 103, the mesa channel region 104 is pinched-off via only one of opposite space charge regions since the first control region 1101 is electrically coupled to the source contact S and the expansion of the related space charge region cannot be controlled via a voltage applied to the gate contact G.

The configuration examples of Figs. 6 and 7 illustrate measures for counteracting an offset in pinch-off voltages (threshold voltages) that may occur when applying different voltages to the control regions confining the mesa channel regions. Different voltages, e.g. gate or source voltage, may be applied to the control regions for adjusting the capacitive behavior of the trench JFET, for example.

The aspects and features mentioned and described together with one or more of the previously described examples and figures, may as well be combined with one or more of the other examples in order to replace a like feature of the other example or in order to additionally introduce the feature to the other example.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A trench junction field effect transistor, trench JFET (100), comprising:
a mesa region (103) confined by first and second trenches (1061, 1062) along a first lateral direction (x1), the first and second trenches (1061, 1062) extending into a semiconductor body (102) from a first surface (108) of the semiconductor body (102);
a mesa channel region (104) of a first conductivity type confined, along the first lateral direction (x1), by first and second control regions (1101, 1102) of a second conductivity type, a first pn junction (1121) being defined by the mesa channel region (104) and the first control region (1101), and a second pn junction (1122) being defined by the mesa channel region (104) and the second control region (1102), and wherein the first control region (1101) is electrically coupled to a source contact (S), and the second control region (1102) is electrically coupled to a gate contact (G).

2. The trench JFET (100) of the preceding claim, wherein the first trench (1061) comprises a dielectric trench filling structure.

3. A trench junction field effect transistor, trench JFET (100), comprising:
a mesa region (103) confined by first and second trenches (1061, 1062) along a first lateral direction (x1), the first and second trenches (1061, 1062) extending into a semiconductor body (102) from a first surface (108) of the semiconductor body (102);
a mesa channel region (104) of a first conductivity type confined, along the first lateral direction (x1), by first and second control regions (1101, 1102) of a second conductivity type, a first pn junction (1121) being defined by the mesa channel region (104) and the first control region (1101), and a second pn junction (1122) being defined by the mesa channel region (104) and the second control region (1102), and wherein each of the first and second trenches (1061, 1062) includes a gate or source electrode (1131, 1132) and a bottom electrode (1141, 1142), the gate or source electrode (1131, 1132) being arranged between the bottom electrode (1141, 1142) and the first surface (108).

4. The trench JFET (100) of the preceding claim, further comprising a dielectric separation region (1161, 1162) arranged between the bottom electrode (1141, 1142) and the gate electrode (1131, 1132).

5. The trench JFET (100) of any of the two preceding claims, wherein each of the first and second control regions (1101, 1102) is divided into a top part (1104) and a bottom part (1105), wherein the top part (1104) and the bottom part (1105) are vertically spaced from one another by an intermediate separation region (1151, 1152) of the first conductivity type.

6. The trench JFET (100) of the preceding claim, wherein the intermediate separation region (1151, 1152) adjoins to the dielectric separation region (1141, 1142) along the first lateral direction (x1).

7. The trench JFET (100) of any of the preceding claims, further comprising a first conductive liner (1171, 1172) at a sidewall portion of at least one of the first and second trenches (1061, 1062), the first conductive liner (1171, 1172) being laterally arranged between a trench filling material in the at least one of the first and second trenches (1061, 1062) and a corresponding one of the first and second control regions (1101, 1102).

8. The trench JFET (100) of any of the preceding claims, further comprising a second conductive liner (1181, 1182) at a bottom portion of at least one of the first and second trenches (1061, 1062), the second conductive liner (1181, 1182) being vertically arranged between a trench filling material in the at least one of the first and second trenches (1061, 1062) and a corresponding one of the first and second control regions (1101, 1102).

9. The trench JFET (100) of any of the preceding claims, further comprising a superjunction structure (120) arranged between a bottom side of the first and second trenches (1061, 1062) and a second surface (109) of the semiconductor body (102) opposite to the first surface (108).

10. The trench JFET (100) of the preceding claim, wherein the superjunction structure (120) includes a first SJ region (121) of the first conductivity type, and a second SJ region (122) of the second conductivity type, wherein the first SJ region (121) is electrically coupled to a drain contact (D) at the second surface (109) of the semiconductor body (102) and to the source contact (S) at the first surface (108) of the semiconductor body (102), and the second SJ region (122) is electrically coupled to the first and second control regions (1101, 1102).

11. The trench JFET (100) of any of the two preceding claims, wherein a vertical extension (t1) of the superjunction structure (120) ranges from 50% to 2000% of a vertical extension (t2) of the first and second trenches (1061, 1062).

12. The trench JFET (100) of any of the preceding claims, further comprising a source region (124) of the second conductivity type arranged on the one of opposite sidewalls of the mesa region (103) that adjoins to the second trench (1062).

13. The trench JFET (100) of any of the preceding claims, further comprising a second mesa region, the second mesa region being wider than the mesa region (103), and wherein the second trench is laterally confined by the mesa region (103) and the second mesa region.

14. The trench JFET (100) of any of the preceding claims, wherein an extent (wm) of the mesa region (103) along the first lateral direction (x1) ranges from 200 nm to 2 µm.

15. The trench JFET (100) of any one of the preceding claims, wherein, along the first lateral direction (x1), the mesa channel region (104) includes, first, second and third mesa channel sub-regions (1041, 1042, 1043) having a same extent (w) along the first lateral direction (x1), and a concentration of dopants of the first conductivity type averaged along the first lateral direction (x1) in the second mesa channel sub-region (1042) is larger than a concentration of dopants of the first conductivity type averaged along the first lateral direction (x1) in each of the first and third mesa channel sub-regions (1041, 1043).
